Europäisches Patentamt

European Patent Office

Office européen des brevets

(19)

(11) Numéro de publication : **0 448 671 B1**

# (12) FASCICULE DE BREVET EUROPEEN

(45) Date de publication du fascicule du brevet :
**14.06.95 Bulletin 95/24**

(51) Int. Cl.$^6$ : **G11B 11/10, G11C 13/06**

(21) Numéro de dépôt : **90914938.7**

(22) Date de dépôt : **05.10.90**

(86) Numéro de dépôt international :
**PCT/FR90/00712**

(87) Numéro de publication internationale :
**WO 91/06099 02.05.91 Gazette 91/10**

(54) **PROCEDE ET DISPOSITIF D'ECRITURE ET DE LECTURE D'INFORMATIONS A PARTIR D'UN SUPPORT A BASE DE MATERIAU FERROELECTRIQUE.**

(30) Priorité : **13.10.89 FR 8913403**

(43) Date de publication de la demande :
**02.10.91 Bulletin 91/40**

(45) Mention de la délivrance du brevet :
**14.06.95 Bulletin 95/24**

(84) Etats contractants désignés :
**AT BE CH DE ES GB IT LI LU NL SE**

(56) Documents cités :
**DE-A- 3 418 567**
**PATENT ABSTRACTS OF JAPAN, Vol. 13, No. 322 (P-902) (3670), 20 Juillet 1989, & JP, A, 190414 (Idemitsu Kosan Co. Ltd) 6 Avril 1989 voir le document en entier & Derwent Abstract 89-147496 (20), le document en entier**
**PATENT ABSTRACT OF JAPAN, Vol. 12, No. 408 (P-778) (3255), 28 Octobre 1988, & JP, A, 63146025 (Nippon Telegr. & Teleph. Corp.) 18 Juin 1988 voir le documenten entier & Derwent Abstracts 88-209392 (30)**
**Proceedings of the IEEE, Vol. 74, No. 11, Novembre 1986, IEEE, (New York, US),W.H. MEIKLEJOHN: "Magnetooptics: a Thermomagnetic Recording Technology", pages1570-1581 voir alinea 2; figure 2**
**PATENT ABSTRACT OF JAPAN, Vol. 9, No. 217 (P-385) (1940), 4 September 1985, & JP, A, 6076092 (Fujitsu K.K.) 30 Avril 1985 voir le document en entier**

(73) Titulaire : **THOMSON-CSF**
**173, Boulevard Haussmann**
**F-75008 Paris (FR)**

(72) Inventeur : **ROBIN, Philippe**
**22, rue Armand-Millet**
**F-92340 Bourg-la-reine (FR)**
Inventeur : **BERGE, Bruno**
**3, chemin des Potiers**
**Goincourt F-60000 Beauvais (FR)**
Inventeur : **BROUSSOUX, Dominique**
**10, rue des Vieux-Gagnons**
**F-91460 Marcoussis (FR)**
Inventeur : **LEGRAND, Jean-François**
**13, rue Sidi-Brahim**
**F-38100 Grenoble (FR)**
Inventeur : **LAJZEROWICZ, Joseph**
**Venon**
**F-38610 Gières (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

EP 0 448 671 B1

## Description

La présente invention concerne le stockage et la lecture d'informations sur un support à base de matériau ferroélectrique. Le stockage peut se faire par adressage électrique ou par adressage optique. La lecture se fait par voie optique.

On connaît bien maintenant les disques optiques numériques qui sont des disques où sont enregistrées sous forme numérique des données lisibles par un procédé optique. L'intérêt principal des disques optiques est leur grande capacité de stockage. Actuellement, les modèles commercialisés sont des disques du type CD-ROM (Compact Disc Read Only Memory), ainsi que des disques à une écriture (WORM). Les disques réinscriptibles à volonté RWM (Read Write Many) n'existant pas encore, la technologie la plus avancée est donc celle correspondant au type WORM.

Le principe actuel de l'écriture des disques optiques repose sur le brûlage local d'une piste composée d'une couche sensible. La lecture se fait par simple réflexion d'un faisceau laser sur la piste, ce qui permet d'observer les zones brûlées comme des bits d'information. La densité d'informations généralement obtenue est de $10^{11}$ bit/m$^2$ (soit 10 $\mu$m$^2$ par bit) et le débit de lecture de l'ordre de 10 Mbit/s.

Les recherches pour mettre au point un disque optique réinscriptible portent principalement sur des procédés magnétooptiques. Un faisceau laser chauffe localement un matériau magnétique à base de terres rares qui est refroidi dans un champ magnétique variable en "gelant" un certain état de polarisation. Le procédé de lecture utilise l'effet Faraday, c'est-à-dire le principe de la rotation de la polarisation de la lumière dans un matériau magnétique. La résolution est assurée par chauffage très localisé au moyen d'un faisceau laser. Cependant, cette technique n'a pas encore pu déboucher sur une application commerciale.

On sait d'autre part que l'on peut utiliser des matériaux ferroélectriques pour réaliser des dispositifs à mémoires. Cependant, les applications de mémoires utilisant les deux états rémanents de la polarisation sont marginales du fait des difficultés qui se présentent à la commutation de la polarisation. Les matériaux ferroélectriques ne peuvent donc pas constituer des analogues électriques aux mémoires magnétiques. Diverses solutions ont été proposées afin d'obtenir des mémoires ferroélectriques qui ne présentent pas ces inconvénients. On peut citer la solution proposée par FR-A-2 595 025 où la lecture de l'information est pyroélectrique et la solution proposée par FR-A-2 604 805 où la lecture de l'information est diélectrique.

La possibilité d'utiliser un polymère ferroélectrique comme matériau pour mémoire optique a été signalée dans l'article "Ferroelectric polymer as an optical material" de T.R. OGDEN et D.M. GOOKIN (Materials Letters, Vol. 3, n° 3, January 1985) et dans le Brevet DE-A-3418567. D'après cet article, des zones ponctuelles peuvent être inscrites sur ce type de matériau par chauffage sélectif au moyen d'un faisceau laser et en présence d'un champ électrique. La lecture des inscriptions ainsi réalisées se fait optiquement en utilisant l'effet de biréfringence induit par l'orientation sous champ électrique des dipôles du matériau ferroélectrique. L'inconvénient de ce procédé de lecture est sa très faible efficacité. En effet, les auteurs annoncent que pour un film de PVDF (polyfluorure de vinylidène) de 30 -m d'épaisseur, la rotation de polarisation de l'onde lumineuse de lecture n'est que de 6°. Le rapport signal/bruit est très faible et l'intensité du courant délivré par un détecteur de l'onde lumineuse de lecture ne révèle qu'une différence de 2 % entre une zone du film correspondant à un bit 0 et une zone du film correspondant à un bit 1.

Le but de la présente invention est de concevoir un système d'écriture et de lecture d'informations à partir d'un support réinscriptible à volonté. Le support est réalisé en matériau ferroélectrique. Le stockage des informations peut se faire par adressage électrique ou par adressage optique. La lecture se fait par voie optique en utilisant la génération de seconde harmonique d'un signal lumineux, méthode qui est très sélective et qui ne s'apparente pas aux méthodes classiques de lecture optique evoquées dans le Brevet DE 3418567.

L'invention a donc pour objet un procédé d'écriture et de lecture d'informations stockées sous forme binaire sur un support d'informations à base de matériau ferroélectrique, comprenant :

- l'inscription de l'information se faisant par polarisation de zones du support correspondant à des bits d'information, les zones inscrites étant soit dans un premier état de polarisation, soit dans un deuxième état de polarisation, la lecture de l'information se faisant optiquement, caractérisé en ce que la lecture se fait en mesurant l'amplitude des signaux lumineux de second harmonique, le support d'information générant, en réponse à des faisceaux lumineux incidents, lesdits signaux lumineux de second harmonique dont l'amplitude varie selon que les zones lues sont dans le premier état de polarisation ou dans le deuxième état de polarisation.

L'invention a aussi pour objet un dispositif d'écriture et de lecture d'informations stockées sous forme binaire sur un support d'information à base de matériau ferroélectrique, à chaque bit d'information correspondant une zone du support, comprenant :

- des moyens permettant l'application d'un champ électrique de polarisation sur le matériau ferroélectrique afin de mettre toutes les zones du support dans un premier état de polarisation,

2

- des moyens permettant de mettre certaines zones du support dans un deuxième état de polarisation afin de réaliser l'inscription, des moyens de lecture optique des informations inscrites sur le support caractérisé en ce que les moyens de lecture comprennent des moyens pour détecter un signal de second harmonique généré par les zones du support d'information, et pour détecter l'amplitude dudit signal de second harmonique, ladite amplitude variant selon que les zones lues sont dans le premier état de polarisation ou dans le deuxième état de polarisation.

L'invention a encore pour objet un procédé de lecture d'informations stockées sous forme binaire sur un support d'informations à base de matériau férroélectrique, les bits d'informations résultant de zones inscrites dans un premier état de polarisation, soit dans un deuxième état de polarisation, la lecture de l'information se faisant optiquement, caractérisé en ce que la lecture se fait en mesurant l'amplitude des signaux lumineux de second harmonique, le support d'information générant, en réponse à des faisceaux lumineux incidents, lesdits signaux lumineux de second harmonique dont l'amplitude varie selon que les zones lues sont dans le premier état de polarisation ou dans le deuxième état de polarisation.

L'invention sera mieux comprise et d'autres avantages apparaîtront à la lecture de la description qui va suivre, donnée à titre non limitatif, en liaison avec les figures annexées parmi lesquelles :
- la figure 1 est un diagramme représentant le cycle d'hystérésis de polarisation d'un matériau ferroélectrique,
- la figure 2 est un diagramme représentant la valeur de la polarisation d'un matériau ferroélectrique en fonction de la température,
- les figures 3 et 4 représentent un support d'informations selon l'invention,
- la figure 5 représente schématiquement une structure d'un dispositif d'inscription par voie électrique selon une variante de l'invention,
- la figure 6 représente schématiquement une structure d'un dispositif d'inscription par voie thermique selon une variante de l'invention,
- la figure 7 illustre le dispositif de lecture selon l'invention.

Lorsqu'un champ électrique $\vec{E}$ est applique à un diélectrique, les particules chargées électriquement et qui forment la matière du diélectrique (électrons, atomes ionisés) se trouvent écartés de leur position d'équilibre d'une distance qui est fonction à la fois de l'intensité du champ $\vec{E}$, des forces électrostatiques de rappel auxquelles ces particules se trouvent soumises, de la fréquence du champ électrique appliqué et de l'arrangement des molécules du diélectrique. Il en résulte une polarisation de la matière que l'on note par le vecteur $\vec{P}$, et qui est égale par définition au produit de la densité des charges déplacées par le vecteur représentatif de ce déplacement. Entre le champ électrique $\vec{E}$ et le vecteur de polarisation lié à la matière $\vec{P}$, il existe une relation matricielle de la forme

$$\vec{P} = ||\chi|| \cdot \vec{E}$$

si l'intensité du champ électrique appliqué n'est pas trop élevée. Si le milieu est isotrope, $||\chi||$ se réduit à un scalaire. Dans le cas général des milieux anisotropes, $||\chi||$ est un tenseur.

Cependant, si on applique au diélectrique un champ électromagnétique intense, de fréquence optique, la polarisation induite n'est plus proportionnelle au champ optique appliqué, mais présente des termes non linéaires proportionnels au carré et au cube des champs appliqués. L'ensemble des effets produits pour ces polarisations non linéaires a été très étudié depuis la découverte par FRANKEN de la génération de second harmonique par un cristal de quartz soumis au rayonnement d'un laser à rubis (P.A. FRANKEN, A.E. HILL, C.W. PETERS, G. WEIMREICH, Phys. Rev. Lett., Vol. 7, 1961, p. 118).

On peut décrire la réponse d'un milieu à l'application d'un champ électromagnétique par le développement de la polarisation induite en série entière du champ électrique appliqué

$$\vec{P} = P' + ||\chi^{(1)}|| \cdot \vec{E} + ||\chi^{(2)}|| \cdot |E| \cdot \vec{E} \quad ||\chi^{(3)}|| \cdot |E|^2 \cdot \vec{E} + \ldots$$

P' étant différent de zéro si le diélectrique est un matériau ferroélectrique.

Le premier terme de ce développement de la polarisation induite représente la polarisation linéaire, alors que le énième terme traduit la réponse non linéaire du énième ordre du milieu au champ appliqué. Les coefficients $\chi^{(n)}$ sont des tenseurs d'ordre $(n+1)$ qu'on appelle tenseurs de susceptibilité non linéaire du énième ordre. Les différents termes contenus dans $\vec{P}$ décroissent très vite avec l'ordre n et ce n'est qu'avec l'apparition des sources lumineuses intenses que représentent les faisceaux lasers qu'on a pu exploiter les effets électrooptiques non linéaires correspondant à la susceptibilité d'ordre 2.

Pour certains diélectriques et sous certaines conditions, une polarisation induite par un faisceau lumineux incident et correspondant à une quantité d'énergie emmagasinée, donne lieu au rayonnement d'une onde oscillant à une fréquence double de celle du faisceau lumineux incident, ce qui correspond à la restitution d'une partie de l'énergie emmagasinée.

L'une des conditions nécessaires pour qu'un diélectrique quelconque puisse générer, par effet non linéaire, une onde représentant le second harmonique d'un faisceau lumineux incident, est que son tenseur susceptibilité d'ordre 2 soit différent de zéro. Les tenseurs $\chi^{(n)}$ étant définis à partir des propriétés des cristaux, on peut fortement restreindre le nombre de coefficients indépendants des tenseurs $\chi^{(n)}$ à $3^{n+1}$ composantes en utilisant les propriétés de symétrie du milieu. C'est ainsi que $\chi^{(2)}$ ne sera différent de zéro que dans des milieux non centrosymétriques. Ceci exclut donc tous les milieux amorphes (verres, polymères classiques) qui sont couramment utilisés en optique des couches minces.

Actuellement, les matériaux les plus couramment utilisés pour obtenir le phénomène de génération de seconde harmonique en optique non linéaire sont des monocristaux minéraux comme le niobate de lithium ou le dihydrogénophosphate de potassium (KDP). Cependant, les composés organiques possèdent dans ce domaine un certain nombre d'avantages sur les sels minéraux. En effet, aux fréquences relevant du domaine de l'optique, les effets non linéaires auxquels ils donnent naissance sont d'origine purement électronique, ce qui conduit à une réponse quasi instantanée de ces matériaux et les qualifie pour des applications dans le domaine du traitement ultra-rapide du signal optique. D'autre part, ils ont un seuil de dommage optique (encore désigné sous le terme de photoréfringence) plus élevé. Enfin, ils offrent un potentiel énorme en ingénierie moléculaire, permettant d'obtenir des matériaux possédant de plus grandes susceptibilités du second ordre.

Les matériaux organiques à fonction optique (doubleur de fréquence, effet Pockels, oscillateur paramétrique, mélangeur optique) peuvent être obtenus avec différents types de matériaux et par différentes techniques de mise en oeuvre.

Un type de structure ordonnée de molécules organiques possédant une réponse non linéaire très grande et capables de générer la seconde harmonique d'une onde électromagnétique est constitué par des polymères. Les films de polymère sont particulièrement intéressants puisqu'ils peuvent être appliqués sur de très grandes surfaces (par rapport à la taille des monocristaux) et sur des substrats de nature variée. Enfin, ils peuvent être produits beaucoup plus rapidement que les monocristaux et pour un faible coût.

La plupart (environ 80 % ) des molécules organiques connues pour leur fort coefficient de non-linéarité cristallisent dans un système centro- symétrique, ce qui entraîne $\chi^{(2)} = 0$. Pour que ce terme soit différent de zéro, il faut orienter les molécules actives en optique non linéaire.

Les matériaux ferroélectriques, du fait qu'ils possèdent une polarisation spontanée, forment un système non-centrosymétrique. Ils peuvent être utilisés pour la génération d'harmonique s'ils sont à la fois transparents aux ondes électromagnétiques et non linéaires (ce qui suppose un indice de réfraction élevé). Ces conditions se trouvent réunies dans beaucoup de ferroélectriques tels que le KDP ou le niobate de lithium déjà cités.

Selon l'invention, on utilise un support d'informations à base de matériau ferroélectrique pour pouvoir stocker des informations sous forme binaire. Le matériau ferroélectrique peut se présenter sous la forme d'une couche déposée sur un substrat. Cette structure est facile à obtenir à partir d'un polymère ferroélectrique déposé par la méthode de la tournette (ou "spin coating" dans la terminologie anglo-saxonne). Le support d'informations comporte également des électrodes permettant d'appliquer à la couche ferroélectrique un champ électrique de polarisation.

Selon l'invention, l'inscription consiste à mettre des zones du matériau ferroélectrique dans des états de polarisation déterminés : un premier état de polarisation correspondant à un bit 0 et un deuxième état de polarisation correspondant à un bit 1. L'inscription peut se faire de deux manières.

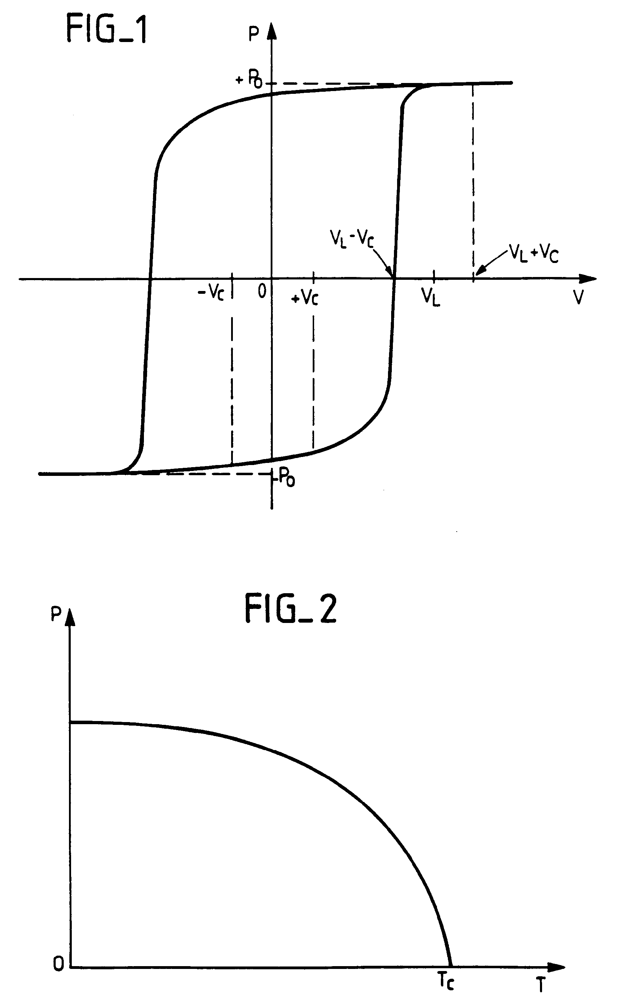

Une première manière consiste à obtenir un état de polarisation déterminé par application d'un champ électrique. La figure 1 représente le cycle d'hystérésis de la polarisation P en fonction d'une tension V (correspondant à un champ électrique E appliqué), chaque zone étant soumise à une polarisation macroscopique. Selon la tension V considérée, on peut obtenir deux états de polarisation (depuis - Po jusqu'à + Po) correspondant l'un à un bit 0 et l'autre à un bit 1.

Une deuxième manière de réaliser l'inscription consiste à obtenir un état de polarisation déterminé par voie thermique. La figure 2 représente la polarisation P en fonction de la température du matériau ferroélectrique. Selon la température à laquelle une zone a été soumise, elle gardera une certaine valeur de polarisation ou n'en aura pas dans le cas où la température était égale ou supérieure à la température de Curie $T_c$.

Selon l'invention, la lecture de l'information se fait optiquement par génération du second harmonique en réponse à un faisceau laser incident aux zones inscrites. L'intensité $I_{(2\omega)}$ du flux lumineux de second harmonique généré par la couche ferroélectrique étant telle que $I_{(2\omega)} = K \times p^2$ (K étant un coefficient de proportionalité), il est avantageux que les signaux de lecture correspondant à deux états de polarisation différents (l'un pour le bit 0 et l'autre pour le bit 1) soient les plus différents possibles. Ceci est possible avec le procédé de l'invention puisqu'on peut inscrire des zones de polarisation Po et des zones de polarisation nulle. Ainsi, par exemple, une zone de polarisation nulle pourra correspondre à un bit O et une zone de polarisation Po à un bit 1.

Dans le cas où l'on prévoit de faire l'inscription par voie électrique, on procédera donc préférentiellement de la façon suivante.

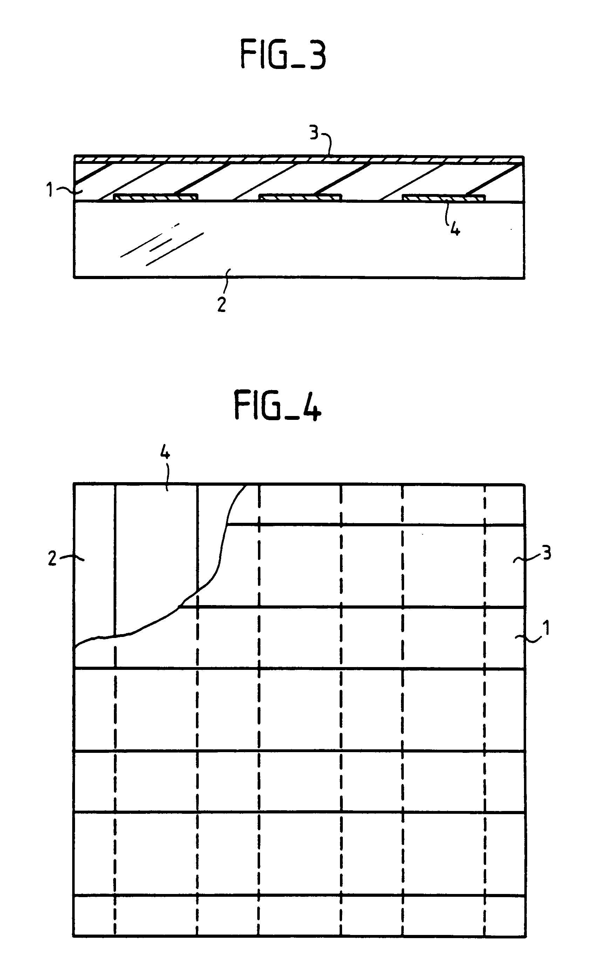

Le support d'information est constitué, comme le montrent les figures 3 et 4, d'une couche 1 de matériau ferroélectrique (préférentiellement un film de polymère) déposée sur un substrat 2. Le substrat peut être en verre. La couche 1 est comprise entre deux jeux d'électrodes transparentes et disposées de façon à former un arrangement matriciel de lignes 3 et de colonnes 4. Les électrodes peuvent être en oxyde mixte d'étain et d'indium (électrodes ITO). L'intersection des lignes et des colonnes définit les zones inscriptibles de la mémoire.

L'inscription s'effectue de la manière suivante. On suppose que toutes les zones de la mémoire sont dans l'état de polarisation - Po. Les lignes 3 de la mémoire sont adressées par des tensions égales soit à 0, soit à $V_L$ tandis que les colonnes 4 sont adressées par des tensions + $V_C$ ou - $V_C$. Les tensions $V_L$ et $V_C$ sont choisies telles que, en fonction du cycle d'hystérésis représenté à la figure 1, on ait une polarisation nulle pour $V_L$ - $V_C$ et une polarisation + Po pour $V_L$ + $V_C$. Pour réaliser l'inscription d'une ligne, il faut appliquer $V_L$ sur cette ligne et une tension nulle sur les autres lignes, et + $V_C$ ou - $V_C$ sur les colonnes selon l'état de polarisation désiré. Les zones de matériau ferroélectrique soumises à une tension $V_L$ + $V_C$ seront dans l'état Po et les zones soumises à une tension $V_L$ - $V_C$ seront dans l'état 0. Les zones des lignes voisines qui ne sont soumises qu'à des tensions + $V_C$ ou - $V_C$, ce qui ne modifie pas leur état - Po. L'inscription peut ainsi se faire ligne par ligne. En appliquant $V_L$ sur toutes les lignes et + $V_C$ sur toutes les colonnes, l'ensemble des zones de la mémoire est soumis à une tension - ($V_C$ + $V_L$) et bascule dans l'état -Po. Le système peut alors être réinscrit.

Dans le cas où l'on prévoit de faire l'inscription par voie thermique, on procédera préférentiellement de la façon suivante. Le support d'information comprend comme précédemment une couche de matériau ferroélectrique déposé sur un substrat. Il faut pouvoir appliquer à la couche ferroélectrique un champ électrique de polarisation. On peut utiliser pour cela une électrode continue disposée entre le substrat et la couche ferroélectrique et obtenir la polarisation par effet Corona.

L'inscription s'effectue de la manière suivante. D'abord, la couche ferroélectrique est polarisée, par effet Corona, à + Po par exemple. Ensuite, grâce à un faisceau laser on chauffe localement certaines zones de la couche de matériau ferroélectrique de manière à porter ces zones au-delà de la température de Curie et à obtenir une polarisation nulle. Ainsi, par exemple, les zones non chauffées donc polarisées correspondent à des bits 1 et les zones chauffées donc dépolarisées correspondent à des bits 0.

On peut utiliser une couche ferroélectrique de poly (fluorure de vinylidène-trifluoroéthylène) ou P (VDF - TrFE) de 10 µm d'épaisseur pour lequel la température de Curie varie entre 55°C et 140°C suivant les proportions de TrFE dans le copolymère. Pour un copolymère de proportions 70/30 (70 % de VDF pour 30 % de TrFE) ayant une température de Curie égale à 110°C, on a besoin d'une énergie de 30 µJ/mm$^2$ déposée en 100 ns, soit une densité de puissance de 300 W/mm$^2$ correspondant à une source de 30 mW pour une longueur d'onde de 0,6 µm, le faisceau laser étant focalisé sur environ 10 µm$^2$ (surface d'une zone inscriptible). On peut ainsi inscrire des zéros de polarisation à la cadence de 10 Mbit/s.

La mise en oeuvre pratique du dispositif permettant l'inscription ne posera pas de problème particulier à l'homme du métier. En effet, que l'inscription se fasse par voie électrique ou par voie thermique on connaît la manière d'agencer les différents éléments des dispositifs d'inscription.

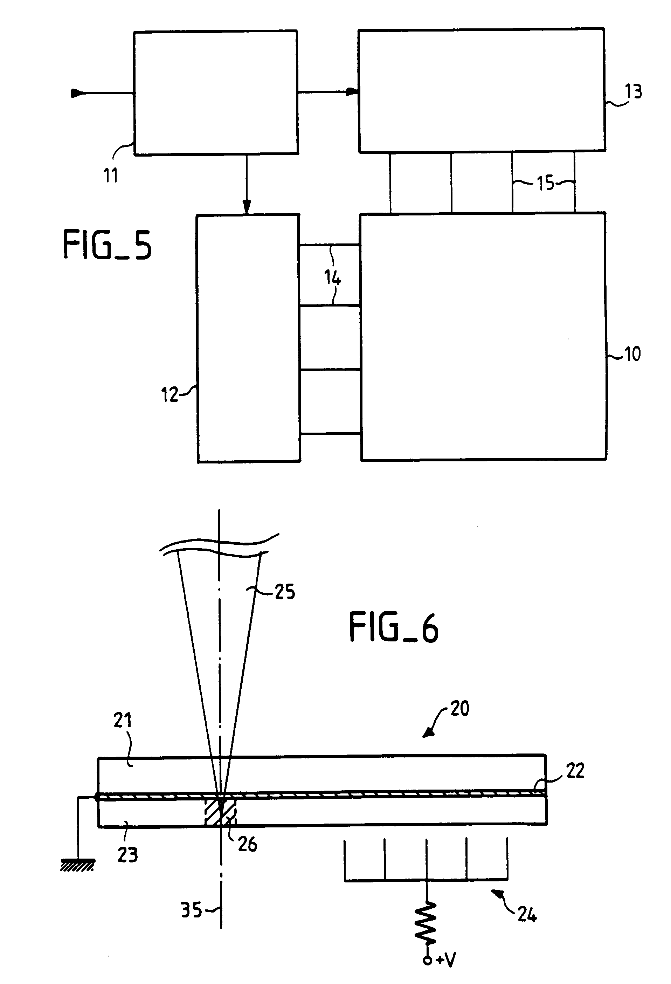

La figure 5 représente schématiquement la structure d'un dispositif d'inscription par voie électrique. Les informations à inscrire dans la mémoire 10 sont fournies sous forme électrique à un circuit 11 qui sépare, vers les circuits de commande lignes 12 (grâce à des connexions électriques 14) et colonnes 13 (grâce à des connexions électriques 15), les signaux d'adressage correspondants. Ce type de dispositif est également utilisé pour la commande des écrans de visualisation à cristaux liquides.

La figure 6 représente schématiquement la structure d'un dispositif d'inscription par voie thermique. Sous la référence 20, on a représenté le support d'information qui est constitué dans ce cas d'un substrat transparent 21, d'une électrode transparente 22 et d'une couche de polymère ferroélectrique 23. Le substrat peut être en verre et a une épaisseur maximale de 1 mm. L'électrode 22 est par exemple en ITO. La couche 23 a environ 10 µm d'épaisseur. Le système de polarisation par effet Corona est représenté symboliquement sous la référence 24. Pour inscrire, la couche ferroélectrique 23 est d'abord polarisée par effet Corona, l'électrode 22 étant à la masse. La polarisation peut se faire en gardant le système de polarisation fixe et en déplaçant le support d'information. Si on veut garder le support fixe, une seconde électrode sera alors déposée sur la couche ferroélectrique 23 et la polarisation se fera par simple application d'un champ électrique entre les deux électrodes encadrant la couche 23. L'inscription des zéros se fait grâce au faisceau laser 25 qui, par transparence du substrat 21 et de l'électrode 22, vient chauffer la zone 26 au-delà de la température de Curie. Les dispositifs permettant de déplacer rapidement un faisceau laser au-dessus d'une surface sont également bien connus et n'ont pas besoin d'être décrits plus en détail.

La lecture optique des informations peut s'effectuer grâce à un faisceau laser de longueur d'onde comprise entre 1,55 et 0,8 µm.

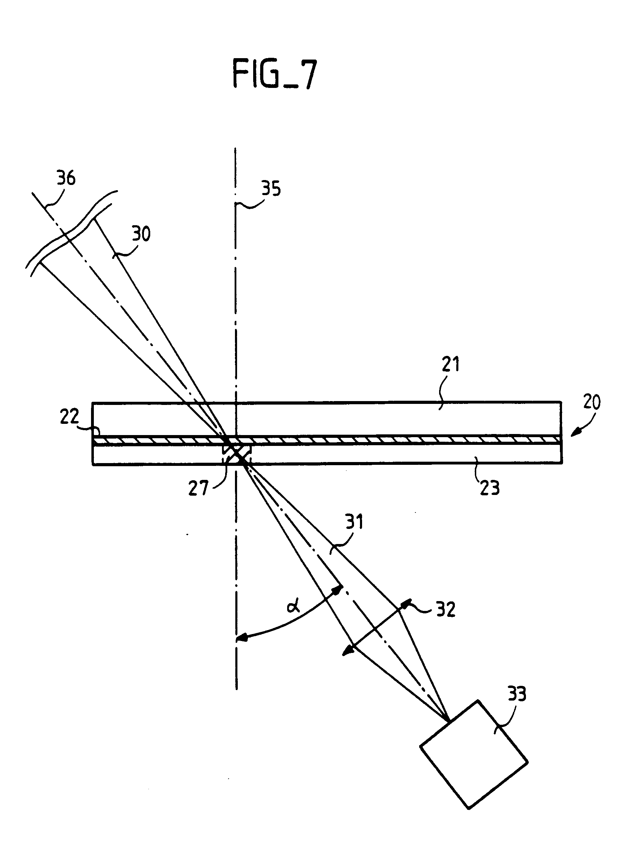

La figure 7 représente le principe du dispositif de lecture selon l'invention. Le support d'enregistrement représenté est celui de la figure 6 concernant l'inscription par voie thermique, mais la lecture d'un support d'enregistrement inscrit par voie électrique s'effectue exactement de la même façon. Le faisceau laser de lecture 30 explore successivement les zones à lire telles que 27. Une zone polarisée Po génère un faisceau lumineux 31 de fréquence double à celle du faisceau incident (soit une longueur d'onde de 0,87 à 0,4 µm dans le cas considéré). Ce faisceau 31 est focalisé par une lentille 32 sur un photodétecteur 33 délivrant un signal I $_{(2\omega)}$ à un circuit de traitement non représenté. L'amplitude de ce signal est proportionnel à Po$^2$. Les zones non polarisées ne génèrent pas de faisceau lumineux à 2$\omega$. Pour recueillir un signal d'amplitude maximale, il est préférable que l'angle $\alpha$ compris entre les axes 35 (axe du faisceau d'inscription) et 36 (axe du faisceau généré) fasse entre 54 et 57°.

La vitesse de lecture est limitée par l'intensité du flux lumineux de second harmonique généré par la couche ferroélectrique. Pour une couche de 10 µm d'épaisseur, une source laser de 30 mW pour 0,96 µm de longueur d'onde focalisée sur 10 µm$^2$ génère une puissance lumineuse de 20 µW pour 0,48 µm de longueur d'onde, soit un rendement d'environ 10$^{-3}$. Cette puissance correspond à 10$^7$ photons émis en 100 ns. Le nombre d'électrons créés dans une photodiode au silicium employée comme photodétecteur correspond à environ 10$^7$. Ce nombre est à comparer avec le bruit capacitif de jonction < Q$^2$ > = C$_j$ x kT (C$_j$ vaut environ 10 pF) correspondant à environ 4.10$^2$ e. Le rapport signal/bruit étant de 10$^4$, le contraste de lecture entre un bit 1 et un bit 0 est suffisant. Ce calcul montre que l'on peut utiliser le signal de second harmonique comme signal de lecture à la cadence de 10 Mbit/s

Pour effacer localement ou totalement la mémoire, il suffit de chauffer localement ou totalement le support d'informations à la température de Curie.

Un autre avantage de la présente invention est constitué par le faible coût du support d'information et la densité importante de stockage. On peut même dans ces conditions envisager d'utiliser ce support comme mémoire de type WORM (Write Once Read Many).

Afin d'améliorer encore le contraste de lecture entre une zone polarisée et une zone non polarisée, on peut inclure dans le matériau ferroélectrique une certaine quantité de molécules à fort coefficient non linéaire (de 0,1 à 10 % en poids). A titre d'exemple, une concentration de 10 % en poids de 4-(4'-cyanophénylazo)-NN-bis-(méthoxycarbonylméthyl)-aniline améliore l'efficacité de génération de second harmonique I$_{2\omega}$/I$_{\omega}$ d'un facteur 100 (voir J R. HILL, P.L. DUNN, G.J. DAVIES, S.N. OLIVER, P. PANTELIS, J.D. RUSH, ELECTRONICS LETTERS 23, 1987, pp. 700-701).

## Revendications

1.  Procédé d'écriture et de lecture d'informations stockées sous forme binaire sur un support d'informations à base de matériau ferroélectrique, comprenant :
    - l'inscription de l'information se faisant par polarisation de zones du support correspondant à des bits d'information, les zones inscrites étant soit dans un premier état de polarisation, soit dans un deuxième état de polarisation, la lecture de l'information se faisant optiquement, caractérisé en ce que la lecture se fait en mesurant l'amplitude des signaux lumineux de second harmonique, le support d'information générant, en réponse à des faisceaux lumineux incidents, lesdits signaux lumineux de second harmonique dont l'amplitude varie selon que les zones lues sont dans le premier état de polarisation ou dans le deuxième état de polarisation.

2.  Procédé selon la revendication 1, caractérisé en ce que l'inscription des zones du support se fait par application d'un champ électrique extérieur

3.  Procédé selon la revendication 2, caractérisé en ce que la valeur du champ électrique extérieur appliqué permet d'obtenir un premier état de polarisation correspondant à la polarisation de valeur maximale.

4.  Procédé selon l'une des revendications 2 ou 3, caractérisé en ce que la valeur du champ électrique extérieur appliqué permet d'obtenir un deuxième état de polarisation correspondant à une polarisation de valeur nulle.

5. Procédé selon la revendication 1, caractérisé en ce que l'inscription des zones du support se fait par voie thermique, le procédé comportant les deux étapes successives suivantes :
   - application d'un champ électrique pour mettre toutes les zones du support d'enregistrement dans un état de polarisation non nulle ou premier état de polarisation,
   - chauffage, jusqu'à une température au moins égale à la température de Curie, des zones du support devant être dans le deuxième état de polarisation.

6. Procédé selon la revendication 5, caractérisé en ce que le chauffage des zones est réalisé grâce à un faisceau laser.

7. Dispositif d'écriture et de lecture d'informations stockées sous forme binaire sur un support d'information à base de matériau ferroélectrique, à chaque bit d'information correspondant une zone du support, comprenant :
   - des moyens permettant l'application d'un champ électrique de polarisation sur le matériau ferroélectrique (1, 23) afin de mettre toutes les zones du support dans un premier état de polarisation,
   - des moyens (12, 13, 25) permettant de mettre certaines zones du support dans un deuxième état de polarisation afin de réaliser l'inscription,
   - des moyens de lecture optique (30, 31, 32, 33) pour lire des informations inscrites sur le support caractérisé en ce que les moyens de lecture comprennent des moyens pour détecter un signal de second harmonique généré par les zones du support d'information, et pour mesurer l'amplitude dudit signal de second harmonique, ladite amplitude variant selon que les zones lues sont dans le premier état ou dans le deuxième état de polarisation.

8. Dispositif selon la revendication 7, caractérisé en ce que les moyens permettant de mettre certaines zones du support dans le deuxième état de polarisation sont constitués par des circuits électriques (12, 13) capables de délivrer à chaque zone du support un champ électrique de polarisation.

9. Dispositif selon la revendication 7, caractérisé en ce que les moyens permettant de mettre certaines zones du support dans le deuxième état de polarisation sont constitués par un faisceau lumineux (25) capable de porter les zones (26) du support (20) à une température égale ou supérieure à la température de Curie.

10. Dispositif selon l'une quelconque des revendications 7 à 9, caractérisé en ce qu'il comprend en outre des moyens permettant d'effacer localement ou en totalité les informations inscrites sur le support par chauffage à une température égale ou supérieure à la température de Curie.

11. Procédé de lecture d'informations stockées sous forme binaire sur un support d'informations à base de matériau ferroélectrique, les bits d'informations résultant de zones inscrites soit dans un premier état de polarisation, soit dans un deuxième état de polarisation, la lecture de l'information se faisant optiquement, caractérisé en ce que la lecture se fait en mesurant l'amplitude des signaux lumineux de second harmonique, le support d'information générant, en réponse à des faisceaux lumineux incidents, lesdits signaux lumineux de second harmonique dont l'amplitude varie selon que les zones lues sont dans le premier état de polarisation ou dans le deuxième état de polarisation.

**Patentansprüche**

1. Verfahren zum Schreiben und Lesen von binären Informationen auf einem Informationsträger auf der Basis von ferroelektrischem Material, wobei das Einschreiben der Information durch Polarisation von Zonen des Trägers entsprechend den Informationsbits erfolgt, derart, daß die beschriebenen Zonen sich entweder in einem ersten Polarisationszustand oder in einem zweiten Polarisationszustand befinden, worauf das Auslesen der Information optisch erfolgt, dadurch gekennzeichnet, daß das Auslesen durch Messen der Amplitude der Lichtsignale der zweiten Harmonischen erfolgt und der Informationsträger aufgrund der einfallenden Lichtstrahlen die Lichtsignale der zweiten Harmonischen erzeugt, deren Amplitude davon abhängt, ob die ausgelesenen Zonen sich im ersten oder im zweiten Polarisationszustand befinden.

2. Verfahren nach Anspruch 1, dadurch gekennzeichnet, daß das Beschreiben der Zonen des Trägers durch Anlegen eines äußeren elektrischen Felds erfolgt.

3.   Verfahren nach Anspruch 2, dadurch gekennzeichnet, daß der Wert des angelegten äußeren elektrischen Felds einen ersten Polarisationszustand entsprechend der Polarisation maximalen Werts ergibt.

4.   Verfahren nach einem der Ansprüche 2 oder 3, dadurch gekennzeichnet, daß der Wert des angelegten äußeren elektrischen Felds einen zweiten Polarisationszustand entsprechend einer Polarisation des Werts Null ergibt.

5.   Verfahren nach Anspruch 1, dadurch gekennzeichnet, daß das Beschreiben der Zonen des Trägers thermisch erfolgt, wobei das Verfahren die beiden folgenden Verfahrensschritte hintereinander aufweist:
     - Anwendung eines elektrischen Felds, mit dem alle Zonen des Aufzeichnungsträgers in einen ersten Polarisationszustand einer Polarisation ungleich Null gelangen,
     - Erwärmung der in den zweiten Polarisationszustand zu bringenden Zonen des Trägers auf eine Temperatur mindestens gleich der Curie-Temperatur.

6.   Verfahren nach Anspruch 5, dadurch gekennzeichnet, daß die Erwärmung der Zonen mit einem Laserstrahl erfolgt.

7.   Vorrichtung zum Schreiben und Lesen von binären Informationen auf einem Informationsträger aus ferroelektrischem Material, wobei jedes Informationsbit einer Zone des Trägers entspricht,
     - mit Mittel, die das Anlegen eines elektrischen Polarisationsfelds an das ferroelektrische Material (1, 23) erlauben, um alle Zonen des Trägers in einen ersten Polarisationszustand zu bringen,
     - mit Mitteln (12, 13, 25), um manche Zonen des Trägers in einen zweiten Polarisationszustand zu bringen, um das Schreiben durchzuführen,
     - mit optischen Lesemitteln (30, 31, 32, 33), um die auf dem Träger eingetragenen Informationen zu lesen, dadurch gekennzeichnet, daß die Lesemittel Mittel aufweisen, um ein Lichtsignal der zweiten Harmonischen zu erfassen, das von den Zonen des Informationsträgers erzeugt wird, und um die Amplitude des Signals der zweiten Harmonischen zu messen, die davon abhängt, ob die gelesenen Zonen sich im ersten oder im zweiten Polarisationszustand befinden.

8.   Vorrichtung nach Anspruch 7, dadurch gekennzeichnet, daß die Mittel, um gewisse Zonen des Trägers in den zweiten Polarisationszustand zu bringen, aus elektrischen Schaltungen (12, 13) bestehen, die jeder Zone des Trägers ein elektrisches Polarisationsfeld liefern können.

9.   Vorrichtung nach Anspruch 7, dadurch gekennzeichnet, daß die Mittel, mit denen gewisse Zonen des Trägers in den zweiten Polarisationszustand gebracht werden können, aus einem Lichtstrahl (25) bestehen, der die Zonen (26) des Trägers (20) auf eine Temperatur mindestens gleich der Curie-Temperatur bringen können.

10.  Vorrichtung nach einem beliebigen der Ansprüche 7 bis 9, dadurch gekennzeichnet, daß sie außerdem Mittel aufweist, um örtlich oder insgesamt die in den Träger eingeschriebenen Informationen durch Erwärmung auf eine Temperatur von mindestens gleich der Curie-Temperatur zu löschen vermögen.

11.  Verfahren zum Lesen von in binärer Form auf einem Informationsträger aus ferroelektrischem Material eingeschriebenen Informationen, wobei die Informationsbits von entweder in den ersten Polarisationszustand oder den zweiten Polarisationszustand gebrachten Zonen gebildet werden und wobei das Auslesen der Information optisch erfolgt, dadurch gekennzeichnet, daß das Auslesen durch Messen der Amplitude der Lichtsignale der zweiten Harmonischen erfolgt, wobei der Informationsträger bei Auffall der Lichtstrahlen die Lichtsignale der zweiten Harmonischen erzeugt, deren Amplitude davon abhängt, ob die gelesenen Zonen sich im ersten oder dem zweiten Polarisationszustand befinden.

## Claims

1.   Method of writing and reading information stored in binary form on an information medium based on a ferroelectric material, comprising:
     - the writing of the information performed by polarising zones of the medium corresponding to information bits, the zones written being in either a first state of polarisation, or in a second state of polarisation, the reading of information being performed optically, characterised in that reading is performed by measuring the amplitude of the second-harmonic light signals, the information medium generating, in response to incident light beams, the said second-harmonic light signals the amplitude of which varies depending on whether the zones read are in the first state of polarisation or in the second state of polarisation.

2. Method according to Claim 1, characterised in that the writing of the zones of the medium is performed by application of an external electric field.

3. Method according to Claim 2, characterised in that the magnitude of the applied external electric field permits the obtaining of a first state of polarisation corresponding to the polarisation of maximum magnitude.

4. Method according to one of Claims 2 or 3, characterised in that the magnitude of the applied external electric field permits the obtaining of a second state of polarisation corresponding to a polarisation of zero magnitude.

5. Method according to Claim 1, characterised in that the writing of the zones of the medium is performed by a thermal route, the method comprising the following two successive steps:
   - application of an electric field in order to place all the zones of the recording medium in a state of non-zero polarisation or first state of polarisation,
   - heating, up to a temperature at least equal to the Curie temperature, of the zones of the medium having to be in the second state of polarisation.

6. Method according to Claim 5, characterised in that the heating of the zones is produced by means of a laser beam.

7. Device for writing and reading information stored in binary form on an information medium based on a ferroelectric material, one zone of the medium corresponding to each information bit, comprising:
   - means permitting the application of a polarising electric field to the ferroelectric material (1, 23) so as to place all the zones of the medium in a first state of polarisation,
   - means (12, 13, 25) permitting certain zones of the medium to be placed in a second state of polarisation so as to produce the writing,
   - optical reading means (30, 31, 32, 33) for reading information written on the medium, characterised in that the reading means comprise means for detecting a second-harmonic signal generated by the zones of the information medium and for measuring the amplitude of the said second-harmonic signal, the said amplitude varying depending on whether the zones read are in the first state or in the second state of polarisation.

8. Device according to Claim 7, characterised in that the means permitting certain zones of the medium to be placed in the second state of polarisation are constituted by electrical circuits (12, 13) capable of delivering a polarising electric field to each zone of the medium.

9. Device according to Claim 7, characterised in that the means permitting certain zones of the medium to be placed in the second state of polarisation are constituted by a light beam (25) capable of bringing the zones (26) of the medium (20) to a temperature equal to or greater than the Curie temperature.

10. Device according to any one of Claims 7 to 9, characterised in that it furthermore comprises means permitting local or total erasing of the information written on the medium by heating to a temperature equal to or greater than the Curie temperature.

11. Method for reading information stored in binary form on an information medium based on a ferroelectric material, the information bits resulting from written zones either in a first state of polarisation, or in a second state of polarisation, the reading of the information being performed optically, characterised in that reading is performed by measuring the amplitude of the second-harmonic light signals the information medium generating, in response to incident light beams, the said second-harmonic light signals the amplitude of which varies depending on whether the zones read are in the first state of polarisation or in the second state of polarisation.

FIG_1

FIG_2

# FIG_3

# FIG_4

FIG_5

11

13

15

14

12

10

FIG_6

25

20

21

22

23

26

35

24

+V

# FIG_7